# EUROPEAN PATENT SPECIFICATION

(11) **EP 2 717 665 B1**
(45) Date of publication and mention of the grant of the patent: **21.06.2017**
(21) Application number: 12793278.8
(22) Date of filing: 23.05.2012
(51) Int. Cl.: H05K 13/04, H05K 13/08, B23K 3/06, H05K 3/00, H05K 3/34, H05K 3/12

(54) **SOLDER MARK SETTING METHOD AND SOLDER MARK SETTING DEVICE**
VERFAHREN ZUR EINSTELLUNG VON LÖTMARKIERUNGEN UND VORRICHTUNG ZUR EINSTELLUNG VON LÖTMARKIERUNGEN
PROCÉDÉ DE RÉGLAGE DE REPÈRE DE BRASURE ET DISPOSITIF DE RÉGLAGE DE REPÈRE DE BRASURE

(30) Priority: 03.06.2011 JP 2011125811
(43) Date of publication of application: 09.04.2014
(73) Proprietor: Fuji Machine Mfg. Co., Ltd., Chiryu-shi, Aichi 472-8686 (JP)
(72) Inventor: KOTANI Kazuya, Chiryu-shi Aichi 472-8686 (JP)
(74) Representative: Grünecker Patent- und Rechtsanwälte PartG mbB
(86) International application number: PCT/JP2012/063212
(87) International publication number: WO 2012/165261

(56) References cited:
- JP-A- 2002 271 096
- JP-A- 2003 060 397
- JP-A- 2005 223 006
- JP-A- 2007 189 101
- JP-A- 2007 189 101
- JP-A- 2007 220 837
- JP-A- 2007 220 837
- JP-A- 2011 029 254
- JP-A- 2011 029 254

## Description

### TECHNICAL FIELD

The present invention relates to a solder paste mark setting method and solder paste mark setting device used to set solder paste marks which are used as a reference for the mounting position of electronic components on a printed circuit board.

### BACKGROUND TECHNOLOGY

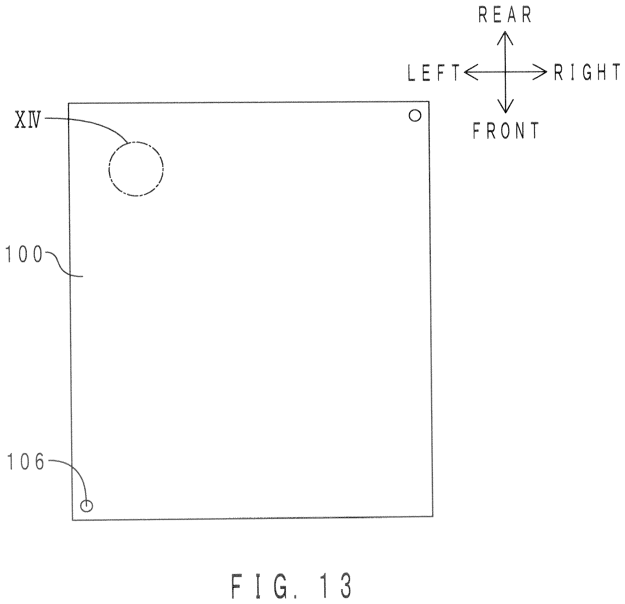

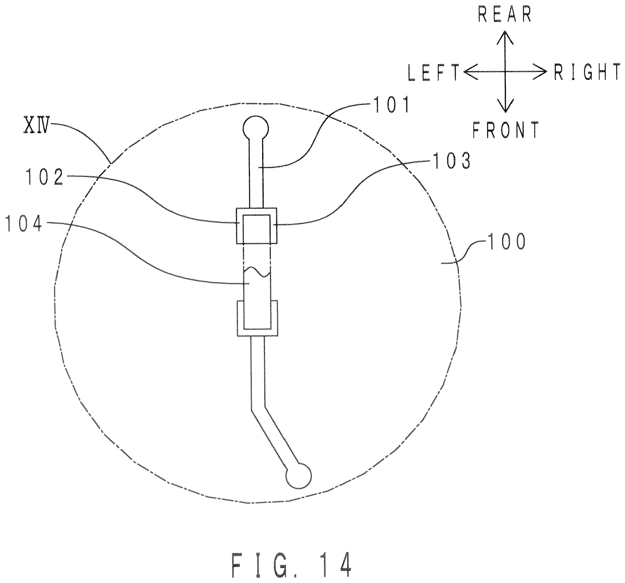

The manufacture of printed circuit boards involves a solder paste printing process, a component mounting process, and a reflow process. FIG. 13 shows a top view of a printed circuit board. FIG. 14 shows an enlarged view of the circular section XIV in FIG. 13. Furthermore, in FIG. 14, a section of electronic component 104 is shown as transparent.

As shown in FIG. 13, a pair of board marks 106 are arranged on the printed circuit board 100. As shown in FIG. 14, during the solder paste printing process, solder paste 103 is deposited on land 102 of the circuit pattern 101 of the printed circuit board 100 by a screen printer. In other words, the screen mask (omitted) of the screen printer has apertures corresponding to solder paste 103. Solder paste is transferred to land 102 of the printed circuit board 100 by pushing solder paste through the apertures from the top side of the screen mask with the bottom surface of the screen mask contacting the upper surface of the printed circuit board 100. During the component mounting process, electronic component 104 is mounted on land 102 (directly on solder paste 103). During the reflow process, printed circuit board 100 is heated and cooled to melt and solidify solder paste 103 to join electronic component 104 to printed circuit board 100.

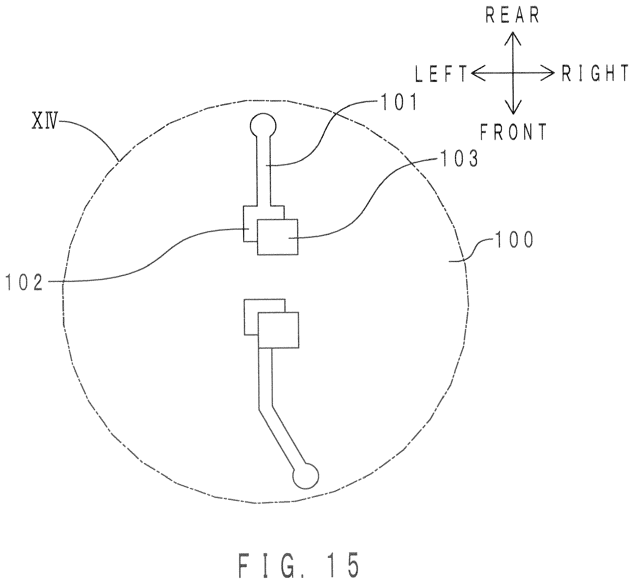

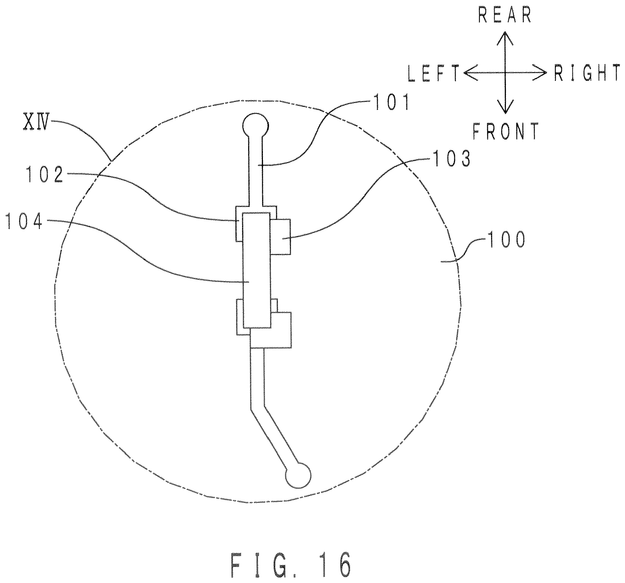

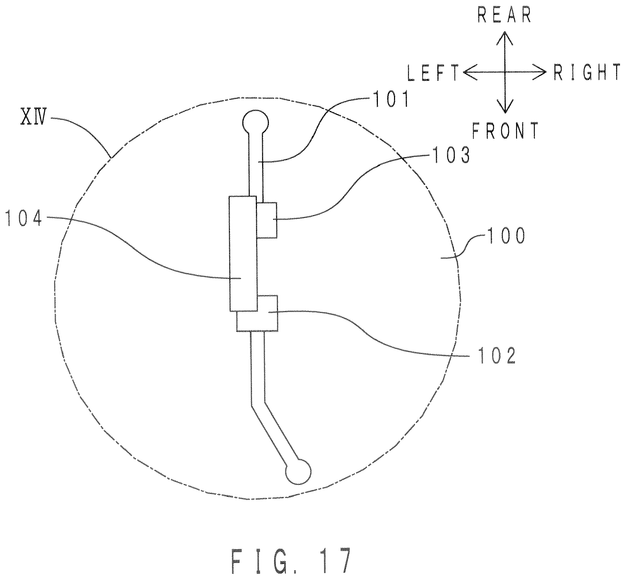

FIG. 15 shows a top view of a section of the printed circuit board after the solder paste printing process. FIG. 16 shows a top view of a section of the printed circuit board after the component mounting process. FIG. 17 shows a top view of a section of the printed circuit board after the reflow process. The elements in these figures correspond to the same numbered elements as given in FIG. 14.

During the solder paste printing process, there are cases in which printed circuit board 100 and the screen mask are misaligned in the horizontal direction. In such a case, as shown in FIG. 15, the printed position of solder paste 103 is misaligned with land 102 of printed circuit board 100.

However, during the component mounting process, electronic component 104 is mounted using the position of land 102 (not the printed position of solder paste 103) as a reference. That is, as shown in FIG. 13, board mark 106 is arranged on printed circuit board 100. The relative positions of board mark 106 and land 102 are known. As shown in FIG. 16, when electronic component 104 is mounted during the component mounting process, the mounting position of electronic component 104 is decided by using the applicable board mark 106 as a reference. Due to this, although the mounting position of the electronic component takes account of the position of land 102, it does not take account of the printed position of solder paste 103.

During the reflow process, when solder paste 103 is melted it flows towards the center of land 102. Due to this, as shown in FIG. 17, the misalignment of solder paste 103 and land 102 can be resolved.

Here, supposing that the mounting position of electronic component 104 takes account of the printed position of solder paste 103, the misalignment of the mounting position of electronic component 104 and the position of land 102 can be resolved by the flow of solder paste 103.

However, the mounting position of electronic component 104 does not take account of the printed position of solder paste 103. Due to this, when solder paste 103 flows, the flow of the liquid solder paste 103 moves electronic component 104 away from land 102. Also, component tombstoning may occur. This tendency is greater the lighter the weight of electronic component 104.

If electronic component 104 is mounted in this way using the position of printed circuit board 100 (or, in other words, land 102) as a reference, after the reflow process the position of electronic component 104 will be misaligned with respect to land 102. Due to this, a method of deciding the mounting position of electronic component 104 using the printed position of solder paste 103 as a reference is desirable.

However, in order to decide the mounting position of electronic component 104 using the printed position of solder paste 103 as a reference, it is necessary to accurately determine the printed position of solder paste 103 on printed circuit board 100.

With regard to this, a component mounting position correction method for correcting the mounting position of an electronic component based on the misalignment amount between the solder paste and a specific land is disclosed in Prior Art 1. According to the component mounting position correction method in this prior art, if the printed position of the solder paste is misaligned with respect to the land, the mounting position of the electronic component can be decided based on the applicable amount of misalignment.

### PRIOR ART REFERENCES

### PRIOR ART

[Prior Art 1] Japanese unexamined patent application

JP-A-2007220837 which discloses a method and a device for mounting an electronic component involving a camera being moved above a substrate mark for recognising the substrate position. Then the substrate mark is imaged simultaneously with a solder mark for recognising the solder print position printed on the substrate mark or in the vicinity thereof.

### BRIEF SUMMARY OF THE INVENTION

### PROBLEM SOLVED BY INVENTION

However, in order to accurately determine the misalignment of the printed position of the solder paste, it is more appropriate to compare the ideal printed position of the solder paste with the actual printed position of the solder paste. In other words, as with the component mounting position correction method disclosed in the prior art, if you use the land as the ideal printed position of the solder paste, it is not possible to determine the misalignment between said ideal printed position of the solder paste and the land. Due to this, it is difficult to accurately determine the misalignment amount of the printed position of the solder paste. That is, it is difficult to accurately correct the mounting position of electronic components.

Also, for the component mounting position correction method in this prior art, it is necessary to determine the misalignment amount of the solder paste with respect to the land after the printed circuit board has had solder paste printed on it (in other words, while there is solder paste on the land). Due to this point also, it is difficult to accurately determine the misalignment amount of the printed position of the solder paste. That is, it is difficult to accurately correct the mounting position of electronic components. As an example, if a printed solder paste deposit which is larger than the corresponding land is printed misaligned, it is difficult to accurately determine the misalignment amount.

The present invention of a solder paste mark setting method and solder paste mark setting device is a complete solution to the above problems. It is the object of the present invention to provide a solder paste mark setting method and solder paste mark setting device which makes it possible to accurately determine the misalignment amount of the solder paste and to accurately correct the mounting position of an electronic component.

### MEANS OF SOLVING THE PROBLEM

(1) To solve the above problems, the solder paste mark setting method of the present invention is characterized in that it captures an image of an area which contains solder paste areas (on which solder paste is deposited) and non solder paste areas (on which solder is not deposited) of a master printed circuit board on which solder paste has been applied to specific positions on the lands of the circuit pattern; has an imaging process in which the image of the area is acquired and the solder paste areas extracted; and has a setting process in which solder marks are set on the master printed circuit board.
   Solder paste has been applied (including by printing) to the lands of the master printed circuit board in an ideal state. That is, the solder paste deposits are arranged with respect to the lands such that there are no defects (such as areas of missing solder paste or streaks of solder paste in unwanted areas). Also, the solder paste deposits are arranged with respect to the lands such that there is no positional misalignment.
   According to the solder paste mark setting method of the present invention, solder paste marks are set based on solder paste deposits which are actually arranged on the master printed circuit board. These solder paste marks are used to determine the misalignment amount of the solder paste for printed circuit boards of the same type as the master printed circuit board. That is, the solder paste marks are used to determine the correction of the mounting position of an electronic component. Due to this, compared to determining the misalignment amount of the printed solder paste based on the lands of the printed circuit board, it is possible to correct the mounting position of an electronic component more accurately.
(2) For the configuration given in (1) above, it is desirable, during the aforementioned imaging process, to illuminate the aforementioned image area with light falling perpendicular onto the image area, and to use the different reflectance ratios of the aforementioned area on which solder paste is deposited and area on which solder paste is not deposited, this being a better configuration by which to emphasize the solder paste.
   The solder paste is formed on the printed circuit board by printing. Due to this, there are many cases in which the solder paste is formed with more fine unevenness than the surface of areas without solder paste (such as the printed circuit board and circuit pattern). As an example, whereas the area without solder paste has a smooth surface, the solder paste area has a rough surface. Due to this, the area with solder paste and the area without solder paste have different reflectance ratios with respect to the illumination.
   According to the present configuration, these different reflectance ratios are used during the imaging process to emphasize the solder paste area of the image. Due to this, the solder paste area can be extracted more accurately during the setting process. It therefore follows that the solder paste mark setting accuracy improves.
(3) For the configuration given in (1) and (2) above, it is desirable for the aforementioned image area to have multiple of the aforementioned solder paste areas and for the aforementioned solder paste mark to be set from multiple solder paste areas, which is a better configuration.
   If the accuracy of the extraction of the solder paste area from the image is poor, the solder mark setting accuracy will be low. Due to this, if a solder mark is set based only on solder paste areas with poor extraction accuracy, the correction accuracy for the mounting position of the electronic component will be lowered.
   For this issue, according to the present configuration, solder paste marks are set based on multiple solder paste areas. Due to this, even if the multiple solder paste areas include a solder paste area for which the extraction accuracy is low, the detrimental effect this has on the solder paste mark setting accuracy can be mitigated. Therefore, the correction accuracy for the mounting position of the electronic component is not lowered as much.
(4) To solve the above problems, the solder paste mark setting device of the present invention is characterized in that it captures an image of an area which contains solder paste areas (on which solder paste is deposited) and non solder paste areas (on which solder is not deposited) of a master printed circuit board on which solder paste has been applied to specific positions on the lands of the circuit pattern; has an imaging section by which the image of the area is acquired and the solder paste areas extracted; and has a control section by which solder marks are set on the master printed circuit board.
   Solder paste has been applied (including by printing) to the lands of the master printed circuit board in an ideal state. That is, the solder paste deposits are arranged with respect to the lands such that there are no defects. Also, the solder paste deposits are arranged with respect to the lands such that there is no positional misalignment.
   According to the solder paste mark setting device of the present invention, solder paste marks are set based on solder paste deposits which are actually arranged on the master printed circuit board. These solder paste marks are used to determine the misalignment amount of the solder paste for printed circuit boards of the same type as the master printed circuit board. That is, the solder paste marks are used to determine the correction of the mounting position of an electronic component. Due to this, compared to determining the misalignment amount of the printed solder paste based on the lands of the printed circuit board, it is possible to correct the mounting position of an electronic component more accurately.
(5) For the configuration given in (4) above, it is further desirable to, with respect to the aforementioned image area, illuminate the image area with light falling perpendicular onto the image area, and to use the different reflectance ratios of the aforementioned area on which solder paste is deposited and area on which solder paste is not deposited, this being a better configuration by which to emphasize the solder paste.
   The solder paste is formed on the printed circuit board by printing. Due to this, there are many cases in which the solder paste is formed with more fine unevenness than the surface of areas without solder paste (such as the printed circuit board and circuit pattern). As an example, whereas the area without solder paste has a smooth surface, the solder paste area has a rough surface. Due to this, the area with solder paste and the area without solder paste have different reflectance ratios with respect to the illumination.
   According to the present configuration, these different reflectance ratios are used to emphasize the solder paste area of the image. Due to this, the solder paste area can be extracted more accurately. It therefore follows that the solder paste mark setting accuracy improves.
(6) For the configuration given in (4) and (5) above, it is desirable for the aforementioned image area to have multiple of the aforementioned solder paste areas and for the aforementioned solder paste mark to be set from multiple solder paste areas, which is a better configuration.

If the accuracy of the extraction of the solder paste area from the image is poor, the solder mark setting accuracy will be low. Due to this, if a solder mark is set based only on solder paste areas with poor extraction accuracy, the correction accuracy for the mounting position of the electronic component will be lowered.

For this issue, according to the present configuration, solder paste marks are set based on multiple solder paste areas. Due to this, even if the multiple solder paste areas include a solder paste area for which the extraction accuracy is low, the detrimental effect this has on the solder paste mark setting accuracy can be mitigated. Therefore, the correction accuracy for the mounting position of the electronic component is not lowered as much.

### EFFECTS OF THE INVENTION

The present invention provides a solder paste mark setting method and solder paste mark setting device which make it possible to accurately determine the misalignment amount of the solder paste and to accurately correct the mounting position of an electronic component.

### BRIEF DESCRIPTION OF THE DRAWINGS

FIG. 1 is a top view of a production line consisting of electronic component mounters which are an exemplary embodiment of the solder mark setting device of the present invention.
FIG. 2 is a perspective view of the same electronic component mounter.
FIG. 3 is a top view of the same electronic component mounter.
FIG. 4 is a block diagram of the same electronic component mounter.
FIG. 5 is a perspective view of the X-direction slider, mounting head, and the vision processing device.
FIG. 6 is a top view of a printed circuit board before the master printed circuit board creation process.
FIG. 7 is a top view of the master printed circuit board after same process.
FIG. 8 is an enlarged view of image area G4 from FIG. 7.
FIG. 9 is an image of image area G4 from FIG. 8.
FIG. 10 (a) is a conceptual view of the gain value adjustment. (b) is a conceptual view of the offset value adjustment.
FIG. 11 is an enlarged view of the circular section XI in FIG. 9.
FIG. 12 is an enlarged image of the section.
FIG. 13 is a top view of a printed circuit board.
FIG. 14 is an enlarged view of the circular section XIV in FIG. 13.
FIG. 15 is a top view of a section of the printed circuit board after the solder paste printing process.
FIG. 16 is a top view of a section of the printed circuit board after the component mounting process.
FIG. 17 is a top view of a section of the printed circuit board after the reflow process.

### SYMBOL DESCRIPTIONS

1 a: Electronic component mounter (solder paste mark setting device), 1b-1d: Electronic component mounters, 1e: Screen printer, 1f: Reflow oven, 2: Base, 3: Module, 4: Tape feeder, 5: Device pallet, 6: Vision processing device, 7: Control device (control section).

30: Printed circuit board conveyance device, 31: XY robot, 32: Mounting head, 35: Printed circuit board raising and lowering device, 36: Housing, 40: Tape, 41: Reel, 42: Reel holder, 60: Mark camera (imaging section), 61: Lighting section, 62: Image processing section, 70: Computer.

303f: Conveyance section, 303fb: Conveyance motor, 303r: Conveyance section, 303rb: Conveyance motor, 304f: Single clamp, 304r: Single clamp, 310: Y-direction slider, 310a: Y-axis motor, 311: X-direction slider, 311a: X-axis motor, 312: Y-direction guide rails, 313: X-direction guide rails, 320: Suction nozzle, 320a: Z-axis motor, 320b: θ-axis motor, 350f: Raising and lowering section, 350fb: Raising and lowering motor, 350r: Raising and lowering section, 610: Light source, 611: Half-silvered mirror, 612: Light beam, 700: Input/output interface, 701: Calculating section, 702: Memory section.

A1: Brightness distribution, A2: Brightness distribution, A3: Brightness distribution, A4: Brightness distribution, Bf: Printed circuit board, Bf0: Master printed circuit board, Bm: Board mark, Br: Printed circuit board, Ca1, Ca2, Cb-Cd: Circuit patterns, Da1, Da2, Db-Dd: Lands, Ea1, Ea2, Eb-Ed: Solder paste sections, Em0: Solder paste mark, F: Floor, G1: Imaging area, G4: Imaging area, G5: Imaging area, K: Intersection point, Lb: Seek line, Lf: Production line, Lr: Production line, Z1: Center of figure, g4: Image.

### MODE FOR CARRYING OUT THE INVENTION

The following describes a mode for carrying out the present invention of a solder paste mark setting method and solder paste mark setting device. In this mode for carrying out the invention, the present invention of a solder paste mark setting device is embodied by an electronic component mounter.

### Production line configuration

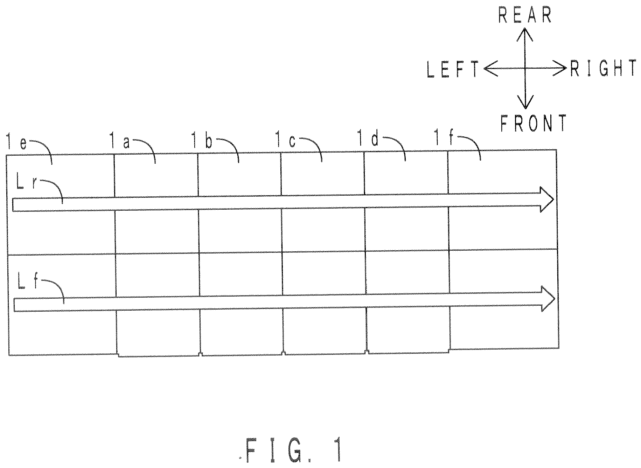

First, we describe simply the configuration of the production line in which the present embodiment of the electronic component mounter (solder paste mark setting device) is arranged. FIG. 1 illustrates a top view of a production line in which the present embodiment of the electronic component mounter is arranged. As shown in FIG. 1, a pair of front/rear production lines Lf and Lr extend in a left/right direction. The left side corresponds to the upstream side of the printed circuit board conveyance direction. The right side corresponds to the downstream side of the printed circuit board conveyance direction. A screen printer 1e, four electronic component mounters 1a to 1d, and a reflow oven 1f are positioned in production lines Lf and Lr. Screen printer 1 e forms solder paste on the lands of the circuit pattern of the printed circuit board by transferring the solder paste. Electronic component mounters 1a to 1d mount components on the solder paste deposits on the printed circuit board according to a preset division of mounting work. Reflow oven 1f heats and cools the printed circuit board with the components mounted on it to melt and solidify the solder paste in order to join the electronic components to the printed circuit board.

From the four electronic component mounters 1a to 1 d, electronic component mounter 1 a is the solder paste mark setting device. That is, electronic component mounter 1a, prior to starting production of any given type of printed circuit board, sets solder paste marks for a master printed circuit board of the same type and on which solder paste deposits are arranged in an ideal state. The data related to the appropriate solder paste marks are shared with all four electronic component mounters 1a to 1d. During production of a printed circuit board, electronic component mounters 1 a to 1d mount electronic components correcting the mounting position based on the appropriate solder paste marks.

### Mechanical configuration of the electronic component mounters

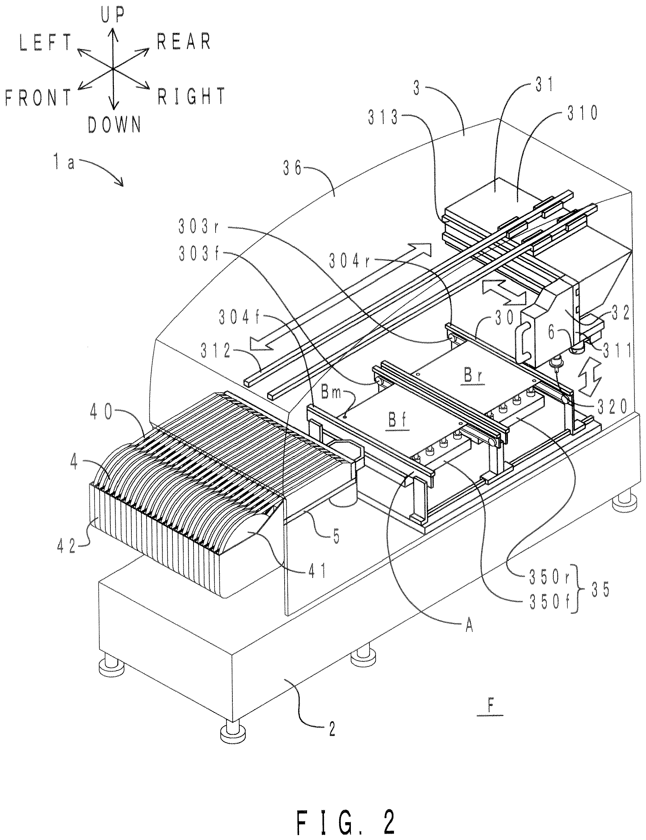

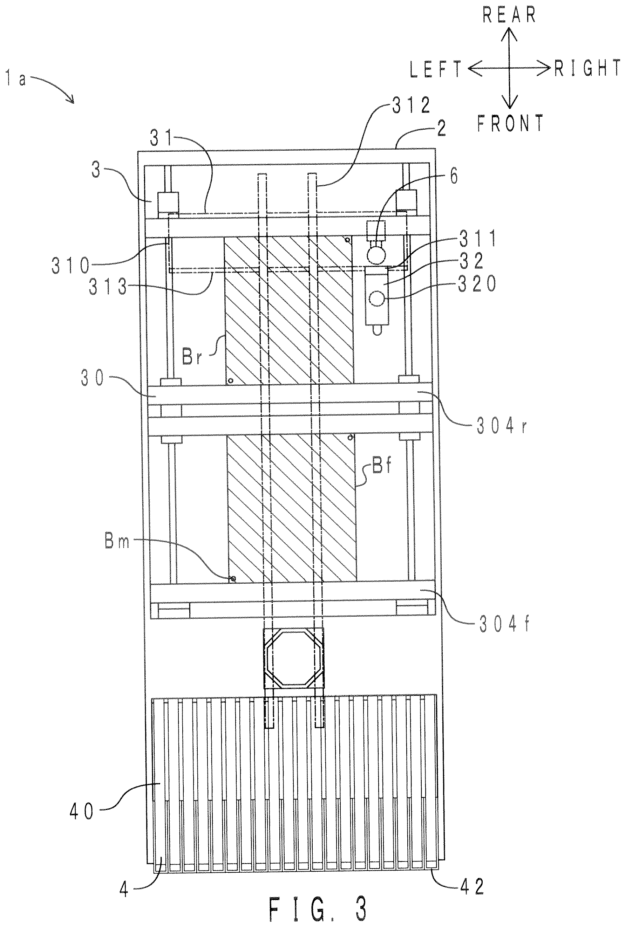

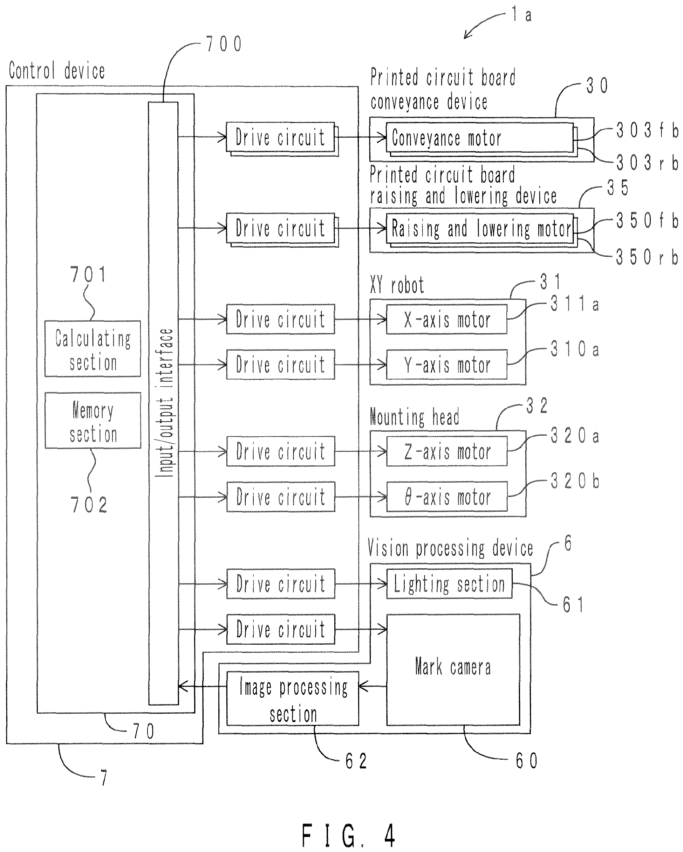

The following describes the mechanical configuration of the electronic component mounters of the present embodiment. FIG. 2 shows a perspective view of an electronic component mounter of the present embodiment. FIG. 3 shows a top view of the same electronic component mounter. FIG. 4 shows a block diagram of the same electronic component mounter.

In FIG. 2, module 3 housing 36 is shown as transparent. In FIG. 3, housing 36 is omitted. As shown in FIG. 2 to FIG. 4, electronic component mounter 1a is equipped with base 2, module 3, multiple tape feeders 4, device pallet 5, image processing device 6, and control device 7.

### Base 2, module 3

Base 2 has a cuboid form. Base 2 is arranged on factory floor F. Module 3 is removably arranged on the upper surface of base 2. Module 3 is equipped with printed circuit board conveyance device 30, XY robot 31, mounting head 32, printed circuit board raising and lowering device 35, and housing 36.

Housing 36 forms the outer shell of module 3. Printed circuit board conveyance device 30 is equipped with a pair of front and rear conveyance sections 303f and 303r, and a pair of front and rear clamp units 304f and 304r. The pair of front and rear conveyance sections 303f and 303r are each equipped with a pair of front and rear belts. Printed circuit boards Bf and Br are being held by each of the two front and rear pairs of belts. The two front and rear pairs of belts can each be rotated by the conveyance motors 303fb and 303rb shown in FIG. 4. Circular marks made of copper foil are present on the left front corner and right rear corner of the upper surface of printed circuit boards Bf and Br. Printed circuit board Bf and printed circuit board Br are conveyed from left to right independently by conveyance section 303f and conveyance section 303r respectively. The front and rear pair of clamp units 304f are arranged on the upper part of conveyance section 303f. The front and rear pair of clamp units 304r are arranged on the upper part of conveyance section 303r.

Printed circuit board raising and lowering device 35 is equipped with a pair of front and rear raising and lowering sections 350f and 350r. The pair of front and rear raising and lowering sections 350f and 350r can each be moved up and down by the raising and lowering motors 350fb and 350rb shown in FIG. 4 and a ballscrew section (omitted). The front side raising and lowering section 350f is arranged on the lower part of conveyance section 303f. The rear side raising and lowering section 350r is arranged on the lower part of conveyance section 303r. The position of printed circuit boards Bf and Br is switched between the conveyance position and the clamp position by the raising and lowering sections 350f and 350r. In the conveyance position, printed circuit boards Bf and Br are set on the conveyance sections 303f and 303r. In the clamp position, the lower surface of printed circuit boards Bf and Br are supported from below by raising and lowering section 350f, 350r. Also, in the clamp position, the front and rear edges of the upper surface of printed circuit boards Bf and Br and pushed from above by the pair of front and rear clamp units 304f and 304r. That is, in the clamp position, printed circuit board Bf, Br is secured by being held from above and below.

Device pallet 5 is set in the front opening of module 3. Multiple tape feeders 4 are each removably set in device pallet 5. Tape feeders 4 are equipped with tape 40, reel 41, and reel holder 42. Multiple electronic components are stored longitudinally in tape 40. Tape 40 is wound around reel 41. Reel 41 is stored in reel holder 42.

The X-direction corresponds to the left-right direction, the Y-direction corresponds to the front-rear direction, and the Z-direction corresponds to the up-down direction. XY robot 31 is equipped with Y-direction slider 310, X-direction slider 311, a pair of left and right Y-direction guide rails 312, and a pair of upper and lower X-direction guide rails 313.

The pair of left and right Y-direction guide rails 312 are arranged on the lower surface of the upper wall of housing 36. Y-direction slider 310 is attached to the pair of left and right Y-direction guide rails 312. Y-direction slider 310 can be moved in the front-rear direction by Y-axis motor 310a as shown in FIG. 4. The pair of upper and lower X-direction guide rails 313 are arranged on the front surface of Y-direction slider 310. X-direction slider 311 is attached to the pair of upper and lower X-direction guide rails 313. X-direction slider 311 can be moved in the left-right direction by X-axis motor 311 a as shown in FIG. 4.

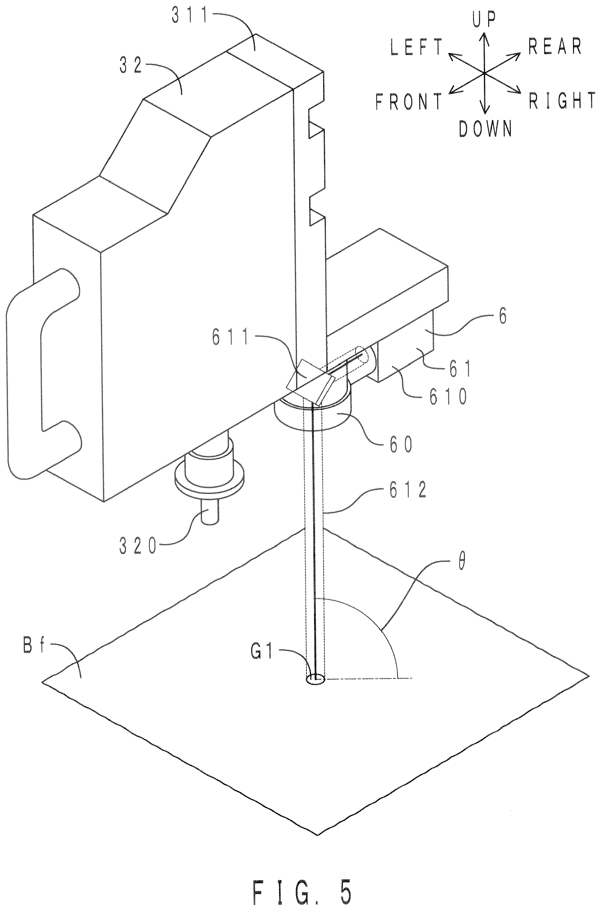

FIG. 5 illustrates a perspective view of the X-direction slider, the mounting head, and the image processing device. As shown in FIG. 5, mounting head 32 is attached to X-direction slider 311. Due to this, mounting head 32 can be moved in the front-rear and left-right directions by XY robot 31. Suction nozzle 320 is exchangeably attached to the lower part of mounting head 32. Suction nozzle 320 can be moved down with respect to mounting head 32 by Z-axis motor 320a as indicated in FIG. 4. Also, suction nozzle 320 can be rotated within a horizontal plane with respect to mounting head 32 by the 8-axis motor 320b as indicated in FIG. 4.

Image processing device 6 is equipped with mark camera 60, lighting section 61, and image processing section 62. Mark camera 60 is included in the concept of the "imaging section" of the present invention. Mark camera 60 and lighting section 61 are, along with mounting head 32, attached to the X-direction slider 311. Due to this, the mark camera 60 and lighting section 61 can be moved in the front-rear and left-right directions by the XY robot 31.

Lighting section 61 is equipped with a light source 610, half-silvered mirror 611, and an optics system (omitted). Light source 610 is an LED (light-emitting diode). As shown by the dotted lines in FIG. 5, the light beam 612 from light source 610 is converted into collimated light by the optics system using lenses and such. Light beam 612 is sent forward to the half-silvered mirror 611 where its direction is changed 90° and reflected down. Due to this, the image area G1 of printed circuit board Bf (and in the same way for printed circuit board Br) illuminated from directly above (perpendicular with respect to image area G1) by light beam 612. The angle of incidence θ of light beam 612 is 90° with respect to image area G1.

Mark camera 60 is a CCD (charge-coupled device) area sensor. Mark camera 60 uses an image surface on which many light-sensitive elements are arranged two-dimensionally. Mark camera 60 acquires an image of image area G1 from directly above (in the direction of incidence of light beam 612).

### Electrical configuration of the electronic component mounters

The following describes the electrical configuration of the electronic component mounters of the present embodiment. As shown in FIG. 4, control device 7 is equipped with computer 70 and multiple drive circuits. Control device 7 is included in the "control section" of the present invention. Computer 70 is equipped with input/output interface 700, calculating section 701, and memory section 702.

Input/output interface 700 is connected via the drive circuits to each of: conveyance motors 303fb and 303rb of printed circuit board conveyance device 30; raising and lowering motors 350fb and 350rb of printed circuit board raising and lowering device 35; X-direction motor 311 a of XY robot 31; Y-axis motor 310a; Z-axis motor 320a of mounting head 32; θ-axis motor 320b; and lighting section 61 and mark camera 60 of image processing device 6. Also, input/output interface 700 is connected to image processing section 62 of image processing device 6.

Date related to the on-machine reference position of electronic component mounter 1a (hereafter referred to as "machine origin position") are stored in memory section 702. Also stored are data related to printed circuit board reference positions Bf and Br (hereafter referred to as "printed circuit board origin position"). Also stored are data related to the printed circuit board origin position with respect to the machine origin position when the clamp position of printed circuit boards Bf and Br are correct. Also stored are data related to the position of a solder paste marks with respect to the printed circuit board origin position of the master printed circuit board (which is acquired by the solder paste mark setting method described hereafter). Also stored are data related to the position of seek lines. Also stored are data related to the intersection points of seek lines and outer dimension lines of solder paste areas used for setting solder paste marks of the master printed circuit board. Also stored are data related to the position of board mark Bm with respect to the printed circuit board origin position. Also stored are data related to the form of board mark Bm. Also stored are data related to the mounting position of the electronic components.

Causes of solder paste position misalignment include: misalignment of the clamp position (conveyance stopping position) of printed circuit boards Bf and Br with respect to electronic component mounter 1 a; and, misalignment of the print position of the solder paste deposits with respect to printed circuit boards Bf and Br.

Calculating section 701 calculates the misalignment amount of the clamp position of printed circuit boards Bf and Br from: data related to the position of the printed circuit board origin position when the clamp position of printed circuit boards Bf and Br is correct (set data); and, data related to the position of the printed circuit board origin position of printed circuit boards Bf and Br during production (measured data).

Also, calculating section 701 calculates the misalignment amount of the print position of the solder paste deposits from: data related to the position of solder paste marks on the master printed circuit board (set data); and, data related to the position of solder paste marks on printed circuit boards Bf and Br during production (measured data). The mounting position of the electronic components is then corrected based on both misalignment amounts.

### Solder paste mark setting method

The following describes a solder paste mark setting method with respect to printed circuit board Bf acting as a representative example for printed circuit boards Bf and Br. The solder paste mark setting method of the present embodiment is performed before the production of printed circuit board Bf. The solder paste mark setting method of the present embodiment uses a master printed circuit board creation process, a printed circuit board loading process, an imaging process, and a setting process.

### Master printed circuit board creation process

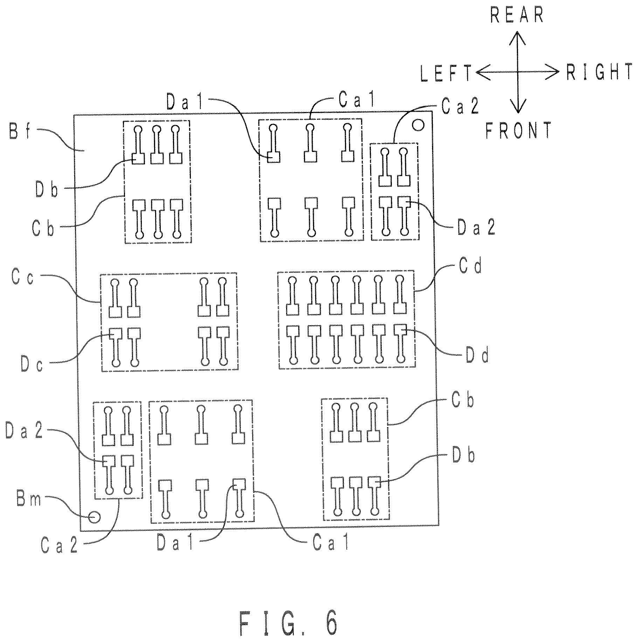

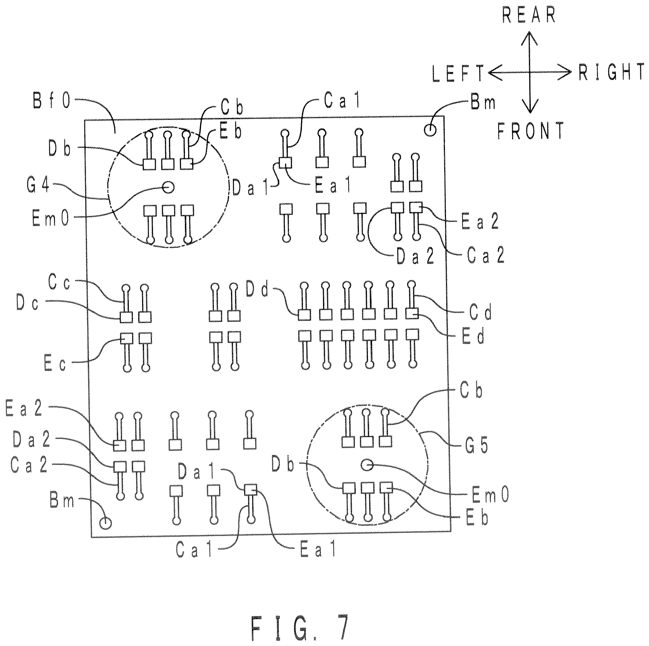

In this process a master printed circuit board is created by printing solder paste on a printed circuit board using screen printer 1e as shown in FIG. 1. A top view of the printed circuit board before the master printed circuit board creation process is shown in FIG. 6. A top view of the master printed circuit board after this process is shown in FIG. 7.

As shown in FIG. 6, there are multiple circuit patterns Ca1, Ca2, Cb-Cd and one board mark Bm on the upper surface of printed circuit board Bf. The circuit patterns Ca1, Ca2, Cb-Cd and board mark Bm are made of copper foil. Printer circuit board Bf, circuit patterns Ca1, Ca2, Cb-Cd and board mark Bm are all flat. Lands Da1, Da2, Db-Dd are formed in the circuit patterns Ca1, Ca2, Cb-Cd.

In this process, solder paste is transferred to lands Da1, Da2, Db-Dd by screen printer 1e as shown in FIG. 1. As shown in FIG. 7, solder paste sections Ea1, Ea2, Eb-Ed are positioned on lands Da1, Da2, Db-Dd on the printed circuit board Bf (that is, master printed circuit board Bf0) in the ideal printed state.

That is, solder paste sections Ea1, Ea2, Eb-Ed are arranged with respect to lands Da1, Da2, Db-Dd such that there are no defects (such as areas of missing solder paste or streaks of solder paste in unwanted areas). Also, solder paste sections Ea1, Ea2, Eb-Ed are arranged with respect to lands Da1, Da2, Db-Dd such that there is no positional misalignment.

### Printed circuit board loading process

In this process, master printed circuit board Bf0 is loaded into electronic component mounter 1a from screen printer 1e as shown in FIG. 1 and then master printed circuit board Bf0 is secured in the clamp position. First, control device 7 as shown in FIG. 4 uses conveyance motor 303fb (that is, the conveyance section 303f as shown in FIG. 2) to convey master printed circuit board Bf0 until it is in the conveyance position directly above raising section 350f. Next, the control device 7 as shown in FIG. 4 uses the raising motors 350fb (that is, the raising section 350f as shown in FIG. 2) to raise master printed circuit board Bf0 from the conveyance position to the clamp position. Following this, master printed circuit board Bf0 is sandwiched and secured in the up and down direction by raising section 350f and pair of front and rear clamp units 304f. Thus, master printed circuit board Bf0 is secured in the correct clamp position.

### Imaging process

In this process, using electronic component mounter 1a shown in FIG. 1, an image for setting solder paste mark Em0 shown in FIG. 7 is acquired from image area G4, G5. First, control device 7 as shown in FIG. 4 moves XY-robot 31 in a horizontal direction using X-axis motor 311a and Y-axis motor 310a. Following this, mark camera 60 and lighting section 61 are positioned so that imaging area G4 includes the six rear left corner solder paste sections Eb as shown in FIG. 7. Next, control device 7 as shown in FIG. 4, after moving lighting section 61, illuminates imaging area G4 with the lighting (refer to FIG. 5).

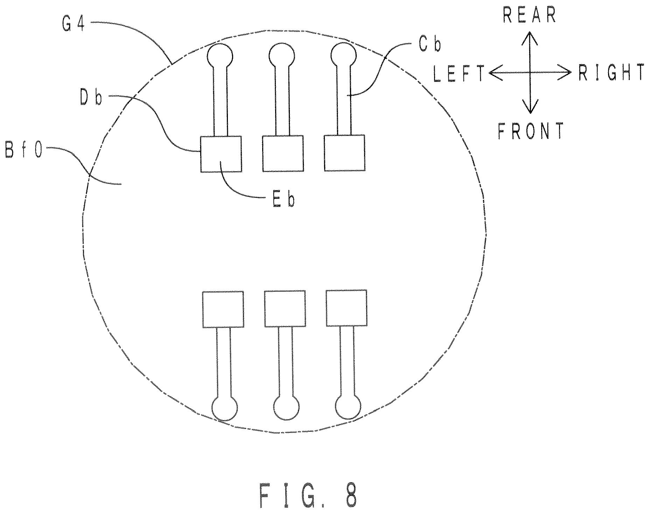

FIG. 8 shows an enlarged view of image area G4 from FIG. 7. As shown in FIG. 8, the upper surface of master printed circuit board Bf0 and the six solder paste sections Eb, and the six circuit patterns Cb (including the six lands Db) are arranged in imaging area G4. In imaging area G4, the upper surface of master printed circuit board Bf0 and six circuit patterns Cb (excluding the printed portions of the six solder paste sections Eb, or in other words, the portions which solder is not deposited on) are included in the concept of "non solder paste areas" of the present invention.

Continuing, control device 7, by operating mark camera 60, takes an image of image area G4. The light exposure time is 100 ms.

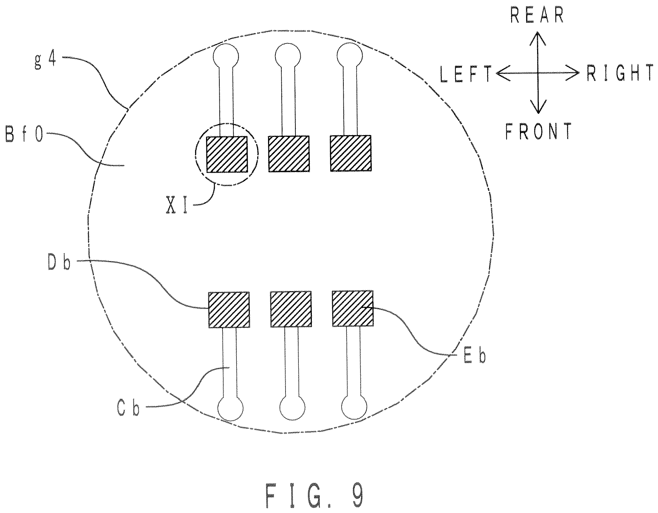

FIG. 9 shows an image of image area G4 from FIG. 8. Both the upper surface of master printed circuit board Bf0 and the six circuit patterns Cb are shiny. Due to this, the reflectance ratios are high with respect to the illumination. Consequently, these sections display as white in image g4. On the other hand, the six solder paste sections Eb are rough. Due to this, the reflectance ratios are low with respect to the illumination. Consequently, these sections display as dark in image g4. From this, due to the difference in the reflectance ratios in image g4, the non solder paste areas are displayed as white and solder paste areas Eb display as dark.

The acquired image g4 is loaded into the image processing section 62 shown in FIG. 4. Image processing section 62 adjusts the gain and offset values of loaded image g4 to increase the brightness contrast difference between the non solder paste areas and solder paste areas Eb.

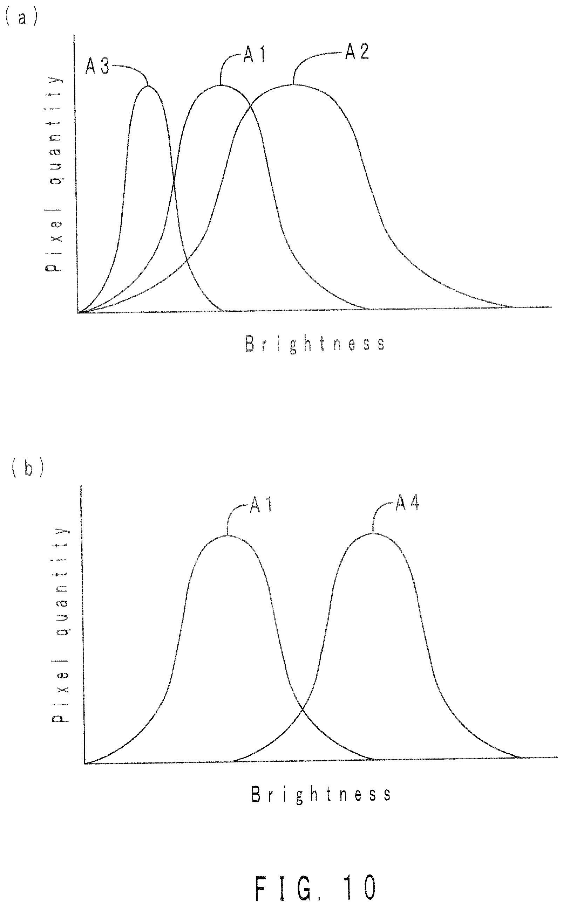

FIG. 10 (a) shows a conceptual view of the gain value adjustment. FIG. 10 (b) shows a conceptual view of the offset value adjustment. As shown in FIG. 10 (a), if the magnification of the gain value exceeds 1, brightness distribution A2 can be expanded with respect to brightness distribution A1 from before adjusting. Also, if the magnification of the gain value is less than 1, the brightness distribution A3 can be narrowed with respect to brightness distribution A1 from before adjusting. In this way, the brightness contrast difference can be enlarged by adjusting the gain values.

As shown in FIG. 10 (b), by adjusting the offset values, the position can be moved from a brightness distribution A1 before adjusting to a brightness distribution position A4 after adjusting while keeping the brightness distribution width the same. In this way, the brightness can be additionally adjusted by adjusting the offset values. The brightness adjusted image g4 is transmitted to control device 7 shown in FIG. 4.

### Setting process

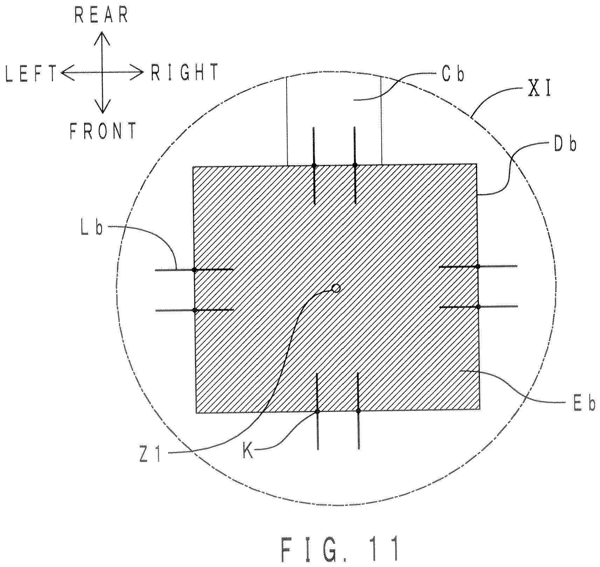

In this process, using electronic component mounter 1a shown in FIG. 1, solder paste mark Em0 shown in FIG. 7 is set. FIG. 11 shows an enlarged view of the circular section XI in FIG. 9. First, control device 7 as shown in FIG. 4 draws a total of 8 seek lines Lb for the solder paste section Eb outer shape edges as shown in FIG. 11. Specifically, seek lines Lb are drawn so that the center of the seek lines bisect at right angles the solder paste section Eb outer shape edges at intersection points K.

Next, control device 7 as shown in FIG. 4 calculates the center for each of the six solder paste sections Eb from image g4 shown in FIG. 9. That is to say, the center Z1 of solder paste sections Eb are calculated based on the intersection points K shown in FIG. 11.

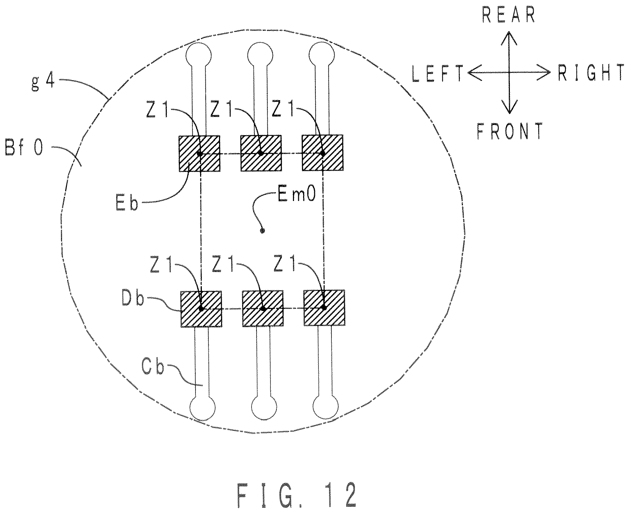

Next, control device 7 as shown in FIG. 4 sets solder paste mark Em0 shown in FIG.7 from the calculated six center Z1 positions. FIG. 12 shows an enlarged image of the section. Furthermore, FIG. 12 corresponds to FIG. 9. As shown in FIG. 12, the center Z1 for each of the six solder paste sections Eb have been set. Calculating section 701 calculates the quadrilateral center of figure formed from connecting centers Z1 and makes the obtained center of the figure the solder paste mark Em0. Data related to the position of solder paste mark Em0 with respect to the printed circuit board origin of master printed circuit board Bf0, and data related to the intersection points K shown in FIG. 11, are transmitted to memory section 702 (refer to FIG. 4) of control device 7 of each of the electronic component mounters 1a-1d shown in FIG. 1. In this way, solder paste mark Em0 is set. Furthermore, by following the same procedures, control device 7 as shown in FIG. 4 sets solder paste mark Em0 for the right front corner in image area G5 shown in FIG. 7.

### Printed circuit board production method

The following describes a production method for printed circuit board Bf acting as a representative example for printed circuit boards Bf and Br. When producing printed circuit board Bf, the appropriate two solder paste marks Em0 are used to perform correction of component mounting positions.

Specifically, control device 7 shown in FIG. 4 first sets two solder paste marks for the printed circuit board Bf in production in the same manner in the above imaging process and setting process.

In other words, control device 7 first determines whether or not there are solder paste sections in the imaging area for setting solder paste marks (whether or not solder paste sections in the image area correspond to solder paste section Eb in imaging areas G4 and G5 from FIG. 7). This determination is performed using seek lines.

Specifically, first, the established position of seek lines Lb are superimposed on the image of printed circuit board Bf. Next, the intersecting points for the seek lines Lb and outer edge of the solder paste section in the image are searched for. Here, if the printed solder paste section in the image is in the ideal state, the eight intersection points K as shown in FIG. 11 should be found. However, there are cases in which there are deviations in the printed circuit board Bf clamp position (conveyance stop position). Also, there are cases in which there are deviations in the printed solder paste positions (including poor printing) on the printed circuit board Bf. These points are taken into account, and when 6 or more of the 8 intersecting points K can be located, control device 7 as shown in FIG. 4 determines that there is a solder paste section Eb in the imaging area which is for setting a solder paste mark. On the other hand, if 6 or more of the 8 intersecting points K cannot be located, the position of seek lines Lb are shifted and a seek line Lb position in which intersection points K can be located is searched for.

Next, control device 7 sets the solder paste mark based on the solder paste section Eb from the imaging area as shown in FIG. 12. In this way, control device 7 specifies two solder paste marks for printed circuit board Bf that is being produced.

Next, control device 7 calculates the misalignment amount between the positions of solder paste marks Em0 on the master printed circuit board Bf0 and the positions solder paste marks on printed circuit board Bf being produced. From this, control device 7 calculates the mounting position correction amount based on the misalignment amount and then corrects the mounting position. Finally, control device 7, by moving XY robot 31 and suction nozzle 320 appropriately, removes the electronic component from tape 40 in tape feeder 4 and mounts it in the corrected mounting position. That is to say, electronic components are mounted on the solder paste sections Ea1, Ea2, Eb-Ed shown in FIG. 7.

In this way, if printed circuit board Bf is produced using solder paste marks Em0*, and there are deviations in the position of solder paste sections Ea1, Ea2, Eb-Ed with respect to the position of lands Da1, Da2, Db-Dd, or if the printing condition of solder paste section Ea1, Ea2, Eb-Ed is defective (for example, the solder paste section Ea1, Ea2, Eb-Ed is scraped or missing), electronic components are mounted based on solder paste sections Ea1, Ea2, Eb-Ed, not based on lands Da1, Da2, Db-Dd.

On the other hand, if printed circuit board Bf is produced using board marks Bm as shown in FIG. 7, it is possible to mount the electronic components based on lands Da1, Da2, Db-Dd, not based on solder paste sections Ea1, Ea2, Eb-Ed.

The mounting position of the electronic components can be determined based on solder paste mark Em0 or it can determined based on board mark Bm; the method can be switched based on the weight of the electronic component to be mounted.

As previously shown in FIG. 15 to 17, when the electronic component 104 weight is light, and there is misalignment between the printed position of solder paste section 103 and land 102, if electronic component 104 is mounted based on land 102, the position misalignment between solder paste section 103 and land 102 is resolved by the reflow process. However, electronic component 104 is moved away from land 102. Also, component tombstoning may occur.

Here, supposing that the mounting position of electronic component 104 takes account of the deviation of the printed position of the solder paste 103, the position deviation between the electronic component 104 (solder paste section 103) and land 102 can be resolved by the reflow process. Due to this, the mounting position for lightweight electronic components 104 is set to be based on solder paste marks Em0.

Conversely, when the electronic component 104 weight is heavy, and there is misalignment between the printed position of solder paste section 103 and land 102, if the electronic component 104 is mounted based on solder paste section 104, it is possible to resolve the misalignment between solder paste section 103 and land 102 by the reflow process; but, on the other hand, it is difficult to move electronic component 104 which is heavy.

Here, if the mounting position of electronic component 104 is not misaligned with respect to land 102, electronic component 104 is not moved even when the reflow process is performed. Due to this, the mounting position for a heavy electronic component 104 is set based on board marks Bm.

In this way, during this method of production of printed circuit board Bf, the mounting position of electronic components is determined based on the solder paste marks Em0 or based on board marks Bm depending on the type of electronic component.

### Effectiveness

The following describes the effectiveness of this embodiment of a solder paste mark setting method and solder paste mark setting device. According to this embodiment of a solder paste mark setting method and solder paste mark setting device, solder paste sections Eb are printed in the ideal state on the master printed circuit board Bf0 lands Db as shown in FIG. 9. That is, the solder paste sections Eb are arranged with respect to lands Db such that there are no defects (such as areas of missing solder paste or streaks of solder paste in unwanted areas). Also, there is no position deviation for solder paste sections Eb with respect to lands Db.

According to this embodiment of a solder paste mark setting method and solder paste mark setting device, as shown in FIG. 7, solder paste marks Em0 are set based on solder paste sections Eb that are actually deposited on master printed circuit board Bf0. Solder paste marks Em0 are used to determine the misalignment amount of the solder paste sections Ea1, Ea2, Eb-Ed on printed circuit boards Bf of the same type as the master printed circuit board Bf0. That is, the solder paste marks are used to determine the correction of the mounting position of an electronic component.

Due to this, compared to determining the misalignment amount of printed solder paste sections Ea1, Ea2, Eb-Ed based on lands Da1, Da2, Db-Dd of printed circuit board Bf, it is possible to correct the mounting position of an electronic component more accurately.

According to this embodiment of a solder paste mark setting method and solder paste mark setting device, as shown in FIG. 5, in the imaging process the lighting unit 612 illuminates image area G1 perpendicularly to this area. Due to this, by using the different reflectance ratios with respect to the light beam 612 of solder paste sections Eb and sections without solder paste, solder paste sections Eb are emphasized. Due to this, as shown in FIG. 11, solder paste sections Eb can be extracted more accurately during the setting process. It therefore follows that the setting accuracy of solder paste marks Em shown in FIG. 7 is improved.

Also, according to this embodiment of a solder paste mark setting method and solder paste mark setting device, as shown in FIG. 12, a single solder mark Em0 is set based on the six solder paste sections Eb. Due to this, even if the six solder paste sections Eb include a solder paste area for which the extraction accuracy is low, the detrimental effect this solder paste section Eb has on the setting accuracy of solder paste mark Em0 can be mitigated. Therefore, the correction accuracy for the mounting position of the electronic component is not lowered as much. Also, there is a decreased possibility of a different solder paste pattern which is nearby being mis-recognized as the solder paste mark.

### Other

The previous described a mode for carrying out the present invention of a solder paste mark setting method and solder paste mark setting device. However, the mode for carrying out this invention is not particularly limited to the above-mentioned mode. People skilled in the art may implement various modified or improved modes.

For example, this is not particularly limited to the configuration and quantity of production line Lf, Lr as shown in FIG. 1. In other words, this is not particularly limited to the quantity of screen printer 1e, electronic component mounters 1a to 1d, and reflow oven 1f that are positioned in production lines Lf and Lr.

Also, this is not limited to the quantity of solder paste sections Eb for setting solder paste mark Em0. Using a single solder paste section Eb is also acceptable. Also, using more than six solder paste sections Eb is also acceptable. There are no limits on the amount of set solder paste marks Em0. One, or three or more is acceptable. There are no limits on the quantity and length of seek lines Lb as shown in FIG. 11. Changing the seek lines Lb shape based on the solder paste section Eb shape is also acceptable. For example, if the solder paste section Eb is a triangular shape, then it is acceptable to use a triangular shape for seek lines Lb. That is, it is better to use seek lines Lb shapes that are similar to solder paste section Eb.

When producing printed circuit board Bf, control device 7 as shown in FIG. 4 calculates the electronic component mounting position offset amount based on the misalignment amount between the position of solder paste marks Em0 on master printed circuit board Bf0 and the position solder paste marks on printed circuit board Bf being produced. There are no limits on the appropriate offset amount calculation method. For example, using the average value of the above deviation amount from the two positions for image area G4 and G5 as shown in FIG. 7 for the electronic component mounting position correction amount is also acceptable. Also, it is also acceptable for an optional compensation coefficient value that is previously stored in the memory section 702 as shown in FIG. 4 to be multiplied by the average value of the appropriate deviation amount to make the correction amount.

Also, unifying the image processing section 62 and control device 7 as shown in FIG. 4 is also acceptable. Also, for solder paste sections used to set solder paste marks Em0, it is also acceptable to use solder paste sections that are not for mounting electronic components. For example, using a solder section specifically for setting solder paste mark Em0 is also acceptable.

In this mode for carrying out the invention, the present invention of a solder paste mark setting device is embodied by an electronic component mounter 1a. That is, the electronic component mounter 1a for production line Lf, Lr as shown in FIG. 1 is the embodiment. However, positioning a solder paste mark setting device independent from production line Lf, Lr is also acceptable. And, transmitting solder paste mark Em0 related data acquired from the solder paste mark setting device to multiple electronic component mounters 1 a-1d of a production line is also acceptable.

There is no limit on the solder paste section Eb extraction method from image g4 as shown in FIG. 9. For example, for a green color printed circuit board Bf, from lighting section 61 as shown in FIG. 5, using a complementary color red light beam 612 to illuminate imaging area G1 is also acceptable. In this way, from the printed circuit board Bf color disappearing, it is possible to extract solder paste sections Eb from image g4 as shown in FIG. 9.

In this mode for carrying out the invention, when 6 or more of the 8 intersecting points K can be located, the control device 7 as shown in FIG. 4 determined that there is a solder paste section for solder paste mark settings for solder paste section Eb in the imaging area. However, there are no limits on the recognition rate (for this case, 6 points out of 8). It is acceptable to adjust the recognition rate based on items such as the absence/presence of electronic components for solder paste sections Eb or the printing conditions of the solder paste sections Eb during production.

In this mode for carrying out the invention, control device 7 as shown in FIG. 4 automatically specifies imaging areas G4 and G5 for setting solder paste mark Em0 as shown in FIG. 7, but it is also acceptable for operators to manually specify imaging areas G4 and G5.

## Claims

1. A printed board production method comprising:
a solder paste mark setting method with
an image process for a master printed circuit board (Bf0) on which solder paste has been deposited at specific positions on the lands (Da1, Da2, Db-Dd) of the circuit pattern (Ca1, Ca2, Cb-Cd) wherein an image (g4) of an image area (G1, G4, G5) of the master printed circuit board (Bf0) is captured wherein said image area (G1, G4, G5) contains solder paste areas (Ea1, Ea2, Eb-Ed) (on which solder paste is deposited) and non solder paste areas (on which solder paste is not deposited) and with
a setting process for setting solder paste marks (Em0) based on said solder paste areas (Ea1, Ea2, Eb-Ed) for said master printed circuit board (Bf0) wherein said solder paste areas (Ea1,Ea2,Eb-Dd) are identified from said image (g4) ;
wherein when producing printed circuit boards of the same type as the master printed circuit board (Bf0), solder paste marks (Em0) for the printed circuit boards in production are set, the misalignment amount between the positions of solder paste marks (Em0) on the master printed circuit board (Bf0) and the positions of solder paste marks (Em0) on printed circuit board in production is calculated, and the component mounting position correction amount is calculated based on said misalignment amount.

2. The printed board production method according to claim 1, wherein said image process illuminates said image area (G1, G4, G5) by a light source from a perpendicular direction; and the different reflectance with respect to the light source of the said solder paste areas (Ea1, Ea2, Eb-Ed) and said non solder paste areas is used to emphasize the solder paste areas (Ea1, Ea2, Eb-Ed).

3. The printed board production method according to claim 1 or 2, wherein said image area (G1, G4, G5) contains multiple solder paste areas (Ea1, Ea2, Eb-Ed) and wherein said solder paste mark (Em0) is set from multiple solder paste areas (Ea1, Ea2, Eb-Ed).

4. A solder paste mark setting device equipped with:
an imaging section (60) which captures an image (g4) of an image area (G1, G4, G5) of a master printed circuit board (Bf0) on which solder paste has been deposited at specific positions on the lands (Da1, Da2, Db-Dd) of the circuit pattern (Ca1, Ca2, Cb-Cd), wherein said image area (G1, G4, G5) contains solder paste areas (Ea1, Ea2, Eb-Ed) (on which solder paste is deposited) and non solder paste areas (on which solder paste is not deposited);
and a control section (7) for extracting said solder paste areas (Ea1, Ea2, Eb-Ed) from said image (g4) and for setting solder paste marks (Em0) on said master printed circuit board.

5. The solder paste mark setting device according to claim 4, equipped with an illumination section (61) for emphasizing the solder paste areas (Ea1, Ea2, Eb-Ed) which illuminates the said image area (G1, G4, G5) by a light source from a perpendicular direction and which uses the different reflectance with respect to the light source of the said solder paste areas (Ea1, Ea2, Eb-Ed) and said non solder paste areas.

6. The solder paste mark setting device according to claim 4 or claim 5, which sets aforementioned solder paste marks (Em0) from multiple solder paste areas (Ea1, Ea2, Eb-Ed) of an aforementioned image area (G1, G4, G5) which contains multiple said solder paste areas (Ea1, Ea2, Eb-Ed).

## Patentansprüche

1. Herstellungsverfahren für Leiterplatten, umfassend:
ein Verfahren zur Einstellung von Lötpastenmarkierungen mit
einem Abbildungsverfahren für eine Master-Leiterplatte (Bf0), auf der Lötpaste an bestimmten Positionen auf den Stegen (Da1, Da2, Db-Dd) des Schaltmusters (Ca1, Ca2, Cb-Cd) aufgebracht wurde, wobei ein Bild (g4) eines Abbildungsbereichs (G1, G4, G5) der Master-Leiterplatte (Bf0) aufgenommen wird, wobei der Abbildungsbereich (G1, G4, G5) Lötpastenbereiche (Ea1, Ea2, Eb-Ed) (auf welchen Lötpaste aufgebracht ist) und Nicht-Lötpastenbereiche (auf welchen keine Lötpaste aufgebracht ist) enthält, und mit
einem Einstellungsverfahren zum Einstellen von Lötpastenmarkierungen (Em0) basierend auf den Lötpastenbereichen (Ea1, Ea2, Eb-Ed) für die Master-Leiterplatte (Bf0), wobei die Lötpastenbereiche (Ea1, Ea2, Eb-Ed) anhand des Bildes (g4) identifiziert werden;
wobei, wenn bei der Herstellung von Leiterplatten desselben Typs wie die Master-Leiterplatte (Bf0) Lötpastenmarkierungen (Em0) für die Leiterplatten in der Produktion eingestellt werden, die Größe der Fehlausrichtung zwischen den Positionen der Lötpastenmarkierungen (Em0) auf der Master-Leiterplatte (Bf0) und den Positionen der Lötpastenmarkierungen (Em0) auf der Leiterplatte in der Produktion berechnet wird, und die Korrekturgröße für die Komponentenmontageposition basierend auf der Größe der Fehlausrichtung berechnet wird.

2. Herstellungsverfahren für Leiterplatten nach Anspruch 1, wobei das Abbildungsverfahren den Abbildungsbereich (G1, G4, G5) mit einer Lichtquelle aus einer lotrechten Richtung beleuchtet; und die andere Reflexion bezüglich der Lichtquelle der Lötpastenbereiche (Ea1, Ea2, Eb-Ed) und der Nicht-Lötpastenbereiche dazu verwendet wird, die Lötpastenbereiche zu betonen (Ea1, Ea2, Eb-Ed).

3. Herstellungsverfahren für Leiterplatten nach Anspruch 1 oder 2, wobei der Abbildungsbereich (G1, G4, G5) multiple Lötpastenbereiche (Ea1, Ea2, Eb-Ed) enthält und wobei die Lötpastenmarkierung (Em0) anhand multipler Lötpastenbereiche (Ea1, Ea2, Eb-Ed) eingestellt wird.

4. Vorrichtung zur Einstellung von Lötpastenmarkierungen, die mit Folgendem ausgestattet ist:
einem Abbildungsabschnitt (60), der ein Bild (g4) eines Abbildungsbereichs (G1, G4, G5) einer Master-Leiterplatte (Bf0) aufnimmt, auf der Lötpaste an bestimmten Positionen auf den Stegen (Da1, Da2, Db-Dd) des Schaltmusters (Ca1, Ca2, Cb-Cd) aufgebracht wurde, wobei der Abbildungsbereich (G1, G4, G5) Lötpastenbereiche (Ea1, Ea2, Eb-Ed) (auf welchen Lötpaste aufgebracht ist) und Nicht-Lötpastenbereiche (auf welchen keine Lötpaste aufgebracht ist) enthält;
und einen Steuerabschnitt (7) zum Extrahieren der Lötpastenbereiche (Ea1, Ea2, Eb-Ed) aus dem Bild (g4) und zum Einstellen der Lötpastenmarkierungen (Em0) auf der Master-Leiterplatte.

5. Vorrichtung zur Einstellung von Lötpastenmarkierungen nach Anspruch 4, die mit einem Beleuchtungsabschnitt (61) zum Betonen der Lötpastenbereiche (Ea1, Ea2, Eb-Ed) ausgestattet ist, der den Abbildungsbereich (G1, G4, G5) mit einer Lichtquelle aus einer lotrechten Richtung beleuchtet und der die andere Reflexion bezüglich der Lichtquelle der Lötpastenbereiche (Ea1, Ea2, Eb-Ed) und der Nicht-Lötpastenbereiche verwendet.

6. Vorrichtung zur Einstellung von Lötpastenmarkierungen nach Anspruch 4 oder 5, welche die zuvor erwähnten Lötpastenmarkierungen (Em0) aus multiplen Lötpastenbereichen (Ea1, Ea2, Eb-Ed) des zuvor erwähnten Abbildungsbereichs (G1, G4, G5) einstellt, der multiple Lötpastenbereiche (Ea1, Ea2, Eb-Ed) enthält.

## Revendications

1. Procédé de production de carte imprimée, comprenant :
un procédé d'établissement de repères de pâte à braser avec
un processus d'image pour une carte à circuit imprimé maître (Bf0) sur laquelle une pâte à braser a été déposée au niveau de positions spécifiques sur les plages d'accueil (Da1, Da2, Db-Dd) du tracé de circuit (Ca1, Ca2, Cb-Cd), dans lequel une image (g4) d'une zone d'image (G1, G4, G5) de la carte à circuit imprimé maître (Bf0) est capturée, dans lequel ladite zone d'image (G1, G4, G5) contient des zones « pâte à braser » (Ea1, Ea2, Eb-Ed) (sur lesquelles une pâte à braser est déposée) et des zones « non pâte à braser » (sur lesquelles aucune pâte à braser n'est déposée), et avec
un processus d'établissement pour établir des repères de pâte à braser (Em0), sur la base desdites zones « pâte à braser » (Ea1, Ea2, Eb-Ed), pour ladite carte à circuit imprimé maître (Bf0), dans lequel lesdites zones « pâte à braser » (Ea1, Ea2, Eb-Ed) sont identifiées à partir de ladite image (g4) ;
dans lequel, lors de la production de cartes à circuit imprimé du même type que la carte à circuit imprimé maître (Bf0), des repères de pâte à braser (Em0) pour les cartes à circuit imprimé en production sont établis, la quantité de désalignement entre les positions des repères de pâte à braser (Em0) sur la carte à circuit imprimé maître (Bf0) et les positions des repères de pâte à braser (Em0) sur la carte à circuit imprimé en production est calculée, et la quantité de correction de la position de montage des composants est calculée sur la base de ladite quantité de désalignement.

2. Procédé de production de carte imprimée selon la revendication 1, dans lequel ledit processus d'image éclaire ladite zone d'image (G1, G4, G5) par une source lumineuse partant d'une direction perpendiculaire ; et le facteur de réflexion différent, par rapport à la source lumineuse, desdites zones « pâte à braser » (Ea1, Ea2, Eb-Ed) et desdites zones « non pâte à braser » est utilisé pour mettre en évidence les zones « pâte à braser » (Ea1, Ea2, Eb-Ed).

3. Procédé de production de carte imprimée selon la revendication 1 ou 2, dans lequel ladite zone d'image (G1, G4, G5) contient de multiples zones « pâte à braser » (Ea1, Ea2, Eb-Ed) et dans lequel ledit repère de pâte à braser (Em0) est établi à partir de multiples zones « pâte à braser » (Ea1, Ea2, Eb-Ed).

4. Dispositif d'établissement de repères de pâte à braser, équipé :
d'une section d'imagerie (60) qui capture une image (g4) d'une zone d'image (G1, G4, G5) d'une carte à circuit imprimé maître (Bf0) sur laquelle une pâte à braser a été déposée au niveau de positions spécifiques sur les plages d'accueil (Da1, Da2, Db-Dd) du tracé de circuit (Ca1, Ca2, Cb-Cd), dans lequel ladite zone d'image (G1, G4, G5) contient des zones « pâte à braser » (Ea1, Ea2, Eb-Ed) (sur lesquelles une pâte à braser est déposée) et des zones « non pâte à braser » (sur laquelle aucune pâte à braser n'est déposée) ;
et d'une section de commande (7) pour extraire lesdites zones « pâte à braser » (Ea1, Ea2, Eb-Ed) de ladite image (g4) et pour établir des repères de pâte à braser (Em0) sur ladite carte à circuit imprimé maître.

5. Dispositif d'établissement de repères de pâte à braser selon la revendication 4, équipé d'une section d'éclairage (61) pour mettre en évidence les zones « pâte à braser » (Ea1, Ea2, Eb-Ed), qui éclaire ladite zone d'image (G1, G4, G5) par une source lumineuse partant d'une direction perpendiculaire et qui utilise le facteur de réflexion différent, par rapport à la source lumineuse, desdites zones « pâte à braser » (Ea1, Ea2, Eb-Ed) et desdites zones « non pâte à braser ».

6. Dispositif d'établissement de repères de pâte à braser selon la revendication 4 ou la revendication 5, qui établit les repères de pâte à braser (Em0) précités à partir de multiples zones « pâte à braser » (Ea1, Ea2, Eb-Ed) d'une zone d'image (G1, G4, G5) précitée qui contient de multiples zones « pâte à braser » (Ea1, Ea2, Eb-Ed).
